Europäisches Patentamt

European Patent Office

Office européen des brevets

(19)

(11) **EP 0 505 283 B1**

(12) **FASCICULE DE BREVET EUROPEEN**

(45) Date de publication et mention
de la délivrance du brevet:
**24.07.1996 Bulletin 1996/30**

(51) Int Cl.6: **H02M 3/335**

(21) Numéro de dépôt: **92400758.6**

(22) Date de dépôt: **20.03.1992**

(54) **Dispositif d'isolement galvanique pour signaux électriques continus ou susceptibles de comporter une composante continue**

Vorrichtung für die galvanische Trennung von Gleichstromsignalen oder eine Gleichstromkomponente enthaltendes Signal

Device for the galvanic insulation of DC electrical signals or signals containing a DC component

(84) Etats contractants désignés:
**AT BE CH DE DK ES FR GB GR IT LI LU NL PT SE**

(30) Priorité: **22.03.1991 FR 9103508**

(43) Date de publication de la demande:
**23.09.1992 Bulletin 1992/39**

(73) Titulaire: **GEC ALSTHOM SA**
**75116 Paris (FR)**

(72) Inventeur: **Alacoque, Jean-Claude**
**F-69360 St Symphorien d'Ozon (FR)**

(74) Mandataire: **Weinmiller, Jürgen et al**
**Lennéstrasse 9**
**Postfach 24**
**82336 Feldafing (DE)**

(56) Documents cités:
**EP-A- 0 013 332**        **US-A- 4 866 587**

- **PATENT ABSTRACTS OF JAPAN vol. 7, no. 33 (E-157)(1178) 9 Février 1983 & JP-A-57183267**
- **ELEKTRONIK vol. 29, no. 24, Novembre 1980, MUNCHEN pages 91 - 94 SMITH 'Die invers-parallele Diode von Leistungs-MOSFETs'**
- **WUSTEHUBE 'Schaltnetzteile' 1982 , VDE-VERLAG**
- **IECON'90 vol. 2, 27 Novembre 1990, PACIFIC GROVE pages 1034 - 1040 RAVINDRA 'Base/gate drive suppression of inactive power devices of a voltage-fed inverter and precision synthesis of AC voltage and DC link current waves'**

## Description

La présente invention concerne un dispositif d'isolement galvanique.

Les besoins en isolement galvanique sont nombreux. Ils sont dictés par des considérations variées :

- fonctionnelles comme par exemple la nécessité de faire plusieurs mesures à des potentiels différents de celui de l'électronique de traitement, au sein d'un système complexe,
- de sécurité de personnes : neutre flottant,
- de disponibilité de distribution électrique : neutre impédant,
- de sécurité de personnes et de matériels : réjection de modes communs importants dûs à des surtensions atmosphériques ou à des manoeuvres sur les lignes de distribution,
- de sécurité de fonctionnement : réjection des tensions et des courants de mode commun dans la transmission à haut débit d'informations binaires.

Ces besoins sont en général bien satisfaits par les solutions actuelles basées pour l'essentiel sur le circuit magnétique d'un transformateur (de potentiel ou de courant) ou sur la fibre optique.

Le transformateur est un moyen connu et simple d'obtenir l'isolement galvanique d'un signal alternatif, référencé par rapport à un potentiel qui peut être quelconque mais qui est en général la terre, une masse ou un potentiel fixe.

Le signal alternatif qu'il est chargé d'isoler peut délivrer une énergie électrique provenant d'un générateur et fournie à un récepteur, ou de l'information, ou bien simultanément de l'énergie et de l'information.

Le transformateur est dimensionné pour une fréquence déterminée ou pour une bande de fréquence, mais il a l'inconvénient de ne pas permettre, seul, la transmission d'un signal continu, et son fonctionnement aux basses fréquences est généralement limité par son dimensionnement.

Le transformateur a cependant l'avantage d'être réversible et de permettre la circulation de l'énergie électrique dans les deux sens, c'est-à-dire pour un transformateur à deux enroulements, d'un des deux bobinages vers l'autre.

Il accepte par ailleurs n'importe quel type de récepteur : inductif, capacitif ou résistif, c'est-à-dire qu'il autorise tout type de déphasage courant/tension et permet pour chaque polarité d'une tension alternative qui lui est appliquée, un courant instantané pouvant être, lui aussi, d'un sens quelconque et ne dépendant, pratiquement, que de la charge.

Enfin, il préserve la forme de l'onde électrique incidente, lorsqu'il est bien dimensionné. Ainsi, une tension alternative modulée en amplitude par un signal véhiculant des informations, pourra-t-elle être transmise, sans déformation sensible, d'un enroulement à l'autre par l'intermédiaire du couplage magnétique entre les deux enroulements

Un autre moyen connu d'obtenir un isolement entre deux circuits électriques est de convertir le signal électrique amont en signal électromagnétique puis de faire la transformation inverse.

Le support intermédiaire de l'information est une onde électromagnétique de fréquence plus élevée que celle du signal électrique incident et qui peut être dans le domaine radio ou dans le domaine lumineux visible ou non. L'onde électromagnétique peut être libre ou guidée (par une fibre optique par exemple).

L'inconvénient de ce procédé est qu'il ne permet pas simplement et économiquement le transport d'énergie significative pour alimenter par exemple une électronique complète de transformation du signal électromagnétique en signal électrique puis d'amplification du signal électrique obtenu. Par ailleurs un signal continu n'est transmis qu'avec une incertitude, quant à son niveau, du fait des dérives, en température et dans le temps, des rendements de conversion électrique/électromagnétique et électromagnétique/électrique ou du fait des variations des pertes dans le milieu de transmission. Pour pallier cet inconvénient un signal continu doit être transposé en fréquence.

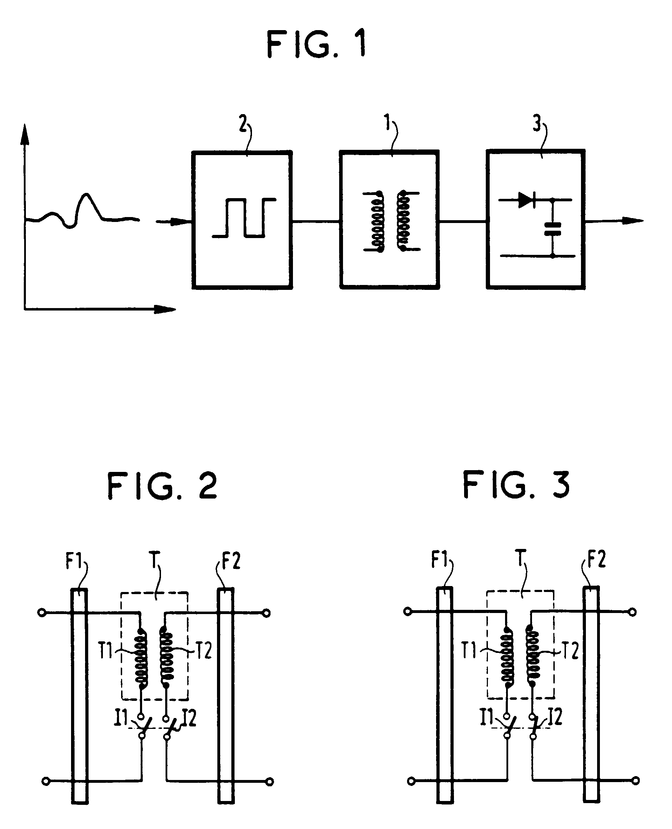

On peut aussi, comme rappelé sur la figure 1, associer à un transformateur 1 des circuits électroniques de découpage, 2, puis de redressement et de filtrage, 3, permettant le transfert d'un signal continu véhiculant de l'énergie, du primaire au secondaire du transformateur.

Il s'agit alors d'une réelle transposition en fréquence dans le domaine de l'énergie.

Toute information éventuellement superposée au signal continu, est alors simultanément échantillonnée -au sens du traitement numérique du signal - par le découpage, et restituée par le redressement-filtrage, dans la mesure où la fréquence de découpage/échantillonnage est au moins deux fois supérieure (théorème de SHANNON) à la plus haute des fréquences à transmettre contenue dans le spectre des fréquences du signal véhiculant l'information.

Le hacheur permettant le découpage du signal continu et l'échantillonnage du signal d'information éventuellement superposé peut utiliser des composants d'une technologie quelconque : thyristors à commutation forcée, GTO, transistors MOS ou bipolaires, IGBT, vibreurs...

L'association du hacheur et du transformateur peut également utiliser un procédé quelconque : direct (forward, push-pull), inverse (fly back), résonnant ou non résonnant.

Selon le procédé utilisé, le transformateur peut, ou non, avoir un enroulement auxiliaire supplémentaire pour la démagnétisation.

Ce principe permet donc d'obtenir l'isolement électrique d'un signal :

- véhiculant ou non de l'énergie permettant par exemple l'alimentation des circuits en aval,
- véhiculant ou non de l'information,
- ayant un spectre de fréquences à transmettre, s'étendant de la fréquence nulle (continu) à la moitié de la fréquence de découpage/échantillonnage.

Il faut cependant noter que les interrupteurs électroniques utilisés dans le hacheur ne sont jamais réversibles, c'est-à-dire qu'ils n'autorisent plus le découpage lorsque le courant qui les traverse tend à s'inverser. Lorsque les composants autorisent le passage en inverse du courant (thyristors asymétriques, transistors MOS...), ils ne permettent plus son blocage (diode inverse). Dans le cas où ces composants permettent simultanément le passage du courant en inverse et le blocage de ce courant, c'est généralement avec des performances très réduites comme dans le cas du transistor bipolaire. De plus, la ou les diodes de redressement au secondaire du transformateur fixent un sens défini pour le courant secondaire. Ces deux considérations impliquent un sens déterminé de la tension et du courant tant au primaire qu'au secondaire, interdisant l'utilisation de ce principe sur une tension dont la polarité change en fonction du temps, ce qui est une première limitation.

Une deuxième limitation provient de ce que le hacheur est d'un côté du transformateur et le redresseur-filtrage, de l'autre côté. Cette disposition fixe un sens à l'écoulement de l'énergie puisqu'elle impose le contrôle du courant magnétisant du transformateur, du côté du hacheur qui est associé à la source.

L'utilisation de ce principe conduit donc à une double dissymétrie quant à :

- la polarité de la tension et du courant,
- le sens d'écoulement de l'énergie.

Il est donc des occurrences où pour les raisons de principe ou pour les raisons technologiques exposées plus haut, l'isolement galvanique n'a pas trouvé de solution acceptable ; c'est le cas lorsque cet isolement galvanique doit s'effectuer sur des signaux électriques continus ou susceptibles de comporter une composante continue et doit en outre présenter une symétrie quant au sens d'écoulement de l'énergie, c'est-à-dire être reversible ; c'est à fortiori le cas lorsque cet isolement galvanique doit en outre présenter une symétrie quant à la polarité des signaux appliqués.

Ainsi les techniques rappelées ci-dessus ne permettent pas économiquement par exemple de réaliser l'isolation électrique de terminaux analogiques ou numériques de télécommunications téléalimentés par exemple, et notamment ne permettent pas de réaliser simultanément les fonctions suivantes :

- transmission d'énergie en continu ou en 50 Hz (60 Hz), ou bien en 50 Hz (60 Hz) superposé à un niveau continu,
- transmission d'information, dans les deux sens, dans une large bande fréquentielle : du continu à des fréquences de plusieurs centaines de kilohertz, pour des transmissions numériques à 144 kilobauds ou bien du continu jusqu'à 12 kHz, 36 kHz ou même 60 kHz pour des transmissions analogiques,
- changement de polarité, sur l'entrée de l'isolation, répercutable en sortie dans le cas d'un signal d'appel en 50 Hz ou 60 Hz, seul ou superposé à un signal continu d'amplitude inférieur à la tension crête du signal à 50 ou 60 Hz dans le cas d'une liaison analogique. Ce changement de polarité peut être simplement l'inversion des deux fils banalisés et non détrompés d'amenée de l'alimentation continue dans le cas d'une liaison analogique ou numérique,
- réversibilité du sens de l'écoulement de la puissance instantanée en 50 ou 60 Hz dans une phase d'appel sur un terminal analogique, pour permettre un fonctionnement sur tout type de charge, en particulier capacitive et autoriser ainsi l'échange d'énergie réactive entre la charge et la source,
- téléalimentation des circuits électriques de l'isolation elle-même ; pour cela le rendement de l'isolation doit être excellent, particulièrement à l'état de veille.

La présente invention a pour but la réalisation des objectifs mentionnés ci-dessus.

Le document JP-A-57 183 267 porte sur un dispositif d'isolement galvanique conforme au préambule de la revendication 1.

La présente invention a pour objet un dispositif d'isolement galvanique tel que défini dans la revendication 1 ci-après.

Suivant une autre caractéristique de l'invention, ce dispositif est réversible et comporte, associés à chacun desdits enroulements, des moyens réversibles de découpage et des moyens de filtrage.

Suivant une autre caractéristique de l'invention, lesdits moyens réversibles de découpage comportent des interrupteurs à semi-conducteurs.

D'autres objets et caractéristiques de la présente invention apparaîtront à la lecture de la description suivante d'exemples de réalisation, faite en relation avec les dessins ci-annexés dans lesquels, outre la figure 1 déjà décrite et relative à l'art antérieur,

- les figures 2 et 3 sont des schémas de principe d'un dispositif d'isolement galvanique réversible suivant l'invention, respectivement suivant deux modes de fonctionnement de ce dispositif,
- les figures 4 et 5 sont des schémas de principe d'un dispositif suivant l'invention, respectivement suivant les modes de fonctionnement des figures 2 et 3, et utilisant en outre la résonance pour diminuer les pertes de commutation dans les semi-conducteurs constituant les interrupteurs électroniques de ce dispositif,

- les figures 6 et 7 sont des variantes des schémas de principe des figures 4 et 5, dans lesquelles les éléments intervenant dans les circuits associés à chacun des enroulements du transformateur ont une disposition déterminée en vue de conférer une structure symétrique à chacun de ces circuits,

- les figures 9 et 10 illustrent deux variantes de réalisation d'un interrupteur (représenté symboliquement sur la figure 8) reversible et utilisant des transistors MOS canal N et leur diode parasite interne, suivant une disposition série,

- les figures 12 et 13 illustrent deux variantes de réalisation d'un interrupteur réversible (représenté symboliquement sur la figure 11) utilisant des transistors MOS canal P et leur diode parasite interne, suivant une disposition série,

- les figures 15, 16, 17, 18 illustrent des variantes de réalisation des schémas des figures 9, 10, 12, 13, applicables pour des fréquences élevées de fonctionnement,

- la figure 19 illustre une variante de réalisation des schémas de principe des figures 2 à 7, dans le cas d'interrupteurs reversibles suivant le mode de réalisation qui fait l'objet des figures 9, 10, 12, 13 et 15 à 18,

- la figure 20 illustre une variante de réalisation du schéma de la figure 19,

- les figures 21 et 22 d'une part, et 23 et 24 d'autre part, sont des chronogrammes illustrant deux modes de commande des quatre interrupteurs élémentaires dits demi-interrupteurs, intervenant dans les schémas des figures 19 et 20,

- les figures 26 à 29 illustrent des variantes de réalisation d'un interrupteur (représenté symboliquement sur la figure 25) reversible, et utilisant des transistors MOS suivant une disposition anti-parallèle,

- la figure 30 illustre une variante de réalisation des schémas de principe des figures 2 à 7, dans le cas d'interrupteurs reversibles suivant le mode de réalisation qui fait l'objet des figures 26 à 29,

- les figures 31 et 32 sont des schémas de réalisation possibles d'un dispositif d'isolement galvanique suivant l'invention, incluant les éléments de commande de ses quatre demi-interrupteurs,

- les figures 33 à 35 sont des modes de réalisation possibles pour l'isolement galvanique de la commande des demi-interrupteurs,

- les figures 37 à 40 reprennent les schémas d'interrupteurs des figures 15 à 18, (le schéma symbolique d'un interrupteur complet étant rappelé en regard sur la figure 36), en leur adjoignant un moyen de détection de courant dans chacun des demi-interrupteurs les constituant,

- les figures 42 et 43 reprennent les schémas d'interrupteurs des figures 26 et 29 (le schéma symbolique d'un interrupteur étant rappelé en regard sur la figure 41), en leur adjoignant un moyen de détection de courant dans chacun des demi-interrupteurs les constituant,

- les figures 44 et 45 reprennent les schémas de réalisation d'un dispositif d'isolement galvanique suivant l'invention, donnés en figures 31 et 32, en leur adjoignant des moyens de détection de courant dans chacun des demi-interrupteurs qu'ils comportent, conformément aux figures 37 pour la figure 44 et 37 et 38 pour la figure 45.

Le dispositif d'isolement illustré sur les figures 2 et 3 est réversible et comporte, pour réaliser l'isolement galvanique proprement dit, un transformateur T par rapport auquel il présente une symétrie de structure, les éléments intervenant dans le circuit de l'un des enroulements du transformateur, l'enroulement de gauche $T_1$ par exemple, étant dans ce qui suit affectés de l'indice 1, et les éléments intervenant dans le circuit de l'autre enroulement, en l'occurrence l'enroulement de droite $T_2$, de l'indice 2. Les fonctions de ces éléments sont maintenant mises en évidence pour un sens donné de propagation des signaux, à titre d'exemple de la gauche vers la droite.

Pour autoriser une large bande passante depuis le continu jusqu'à des fréquences de plusieurs centaines de kilohertz, ce dispositif comporte des moyens réversibles de découpage du signal incident appliqué à l'enroulement $T_1$, symbolisés par un interrupteur $I_1$ et, des moyens de découpage du signal obtenu à l'enroulement $T_2$, symbolisés par un interrupteur $I_2$ qui est commandé à la même fréquence que l'interrupteur $I_1$ , et, soit en phase (les deux interrupteurs sont ouverts ou fermés en même temps), ce qui correspond au mode de fonctionnement représenté sur la figure 2, soit en opposition de phase (un interrupteur est fermé pendant que l'autre est ouvert et réciproquement), ce qui correspond au mode de fonctionnement représenté sur la figure 3.

Ce dispositif comporte ensuite des moyens de filtrage, en l'occurrence $F_2$, du signal découpé ainsi obtenu à l'enroulement $T_2$ en vue de restituer un signal non découpé.

Le même type de description pourrait être fait pour l'autre sens de propagation des signaux, à savoir de la droite vers la gauche, avec les moyens réversibles de découpage $I_2$, $I_1$ et avec les moyens de filtrage $F_1$.

Dans un cas comme dans l'autre, lorsque les interrupteurs $I_1$ et $I_2$ sont commandés simultanément, la composante continue et/ou la composante alternative du signal sont transférées pendant le temps de fermeture des interrupteurs. Dans le cas où les interrupteurs $I_1$ et $I_2$ sont commandés à l'alternat la composante continue et/ou la composante alternative du signal sont transférés au circuit magnétique du transformateur pendant la fermeture de l'un des interrupteurs ($I_1$ si l'énergie s'écoule de gauche à droite sur la figure précédente, $I_2$ dans le cas contraire) sous forme d'induction magnétique, puis se traduit en signal électrique pendant la fermeture de l'autre interrupteur ($I1_2$ si l'énergie s'écoule de gauche à droite sur la figure précédente, $I_1$ dans le cas contraire).

Le circuit magnétique peut être matérialisé par des tôles ou des ferrites magnétiques ou simplement être constitué du champ magnétique de couplage entre les deux bobines dans l'air.

Aucun sens de couplage des enroulements du transformateur n'est représenté sur les figures du fait qu'il n'influence pas le fonctionnement. Celui-ci reste identique à une inversion près de tension, qui n'a souvent aucune incidence, en particulier dans les installations téléphoniques où les conducteurs ne sont pas repérés. On peut d'ailleurs noter que pour un couplage identique du transformateur la tension de sortie du schéma de la figure 3 est inversée par rapport à celle du schéma de la figure 2.

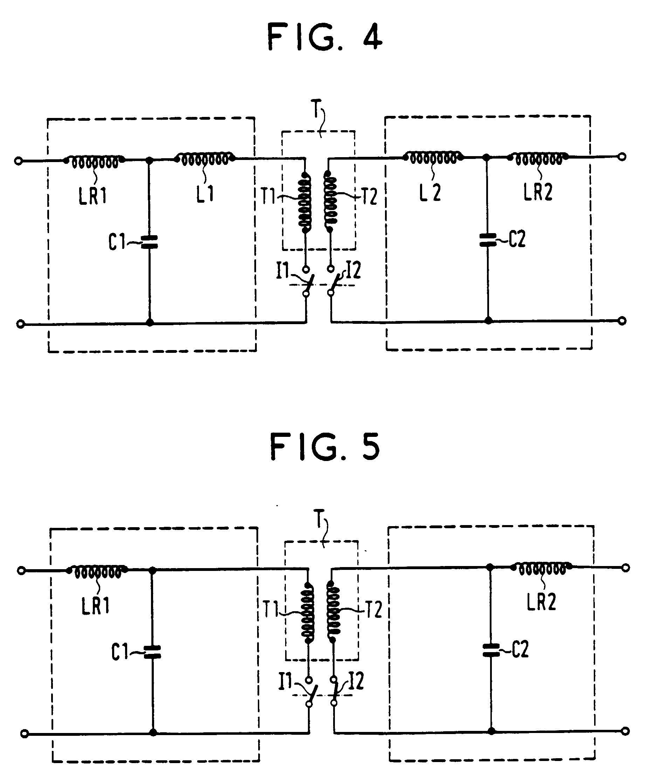

Le fonctionnement de base n'est pas modifié par l'utilisation de la résonnance qui diminue considérablement les pertes de commutation dans les semi-conducteurs constituant les interrupteurs électroniques $I_1$, $I_2$. Cette résonnance s'obtient en ajoutant des capacités, respectivement $C_1$ et $C_2$, et éventuellement des inductances, respectivement $L_1$ et $L_2$, aux schémas de base des figures 2 et 3 pour former par exemple les schémas des figures 4 et 5, où les moyens de filtrage $F_1$ et $F_2$ sont à titre d'exemple formés par des inductances $LR_1$ et $LR_2$ de réjection différentielle de la fréquence de découpage.

Dans le premier cas (figure 4) la résonnance intéresse le circuit série $C_1$, $L_1$, $L_2$, $C_2$ et donc essentiellement les inductances de fuite du transformateur, complétées éventuellement d'inductances extérieures supplémentaires, alors que dans le deuxième cas (figure 5) deux circuits résonnants se constituent avec chacune des capacités $C_1$, $C_2$ et l'inductance magnétisante correspondante, en alternance.

Dans le premier cas l'une des deux inductances $L_1$ ou $L_2$ ou les deux inductances peuvent être supprimées et être représentées par les inductances de fuite du transformateur si celles-ci sont suffisantes pour l'application. Les capacités $C_1$ et $C_2$ sont des capacités d'accord pour la fréquence de résonnance.

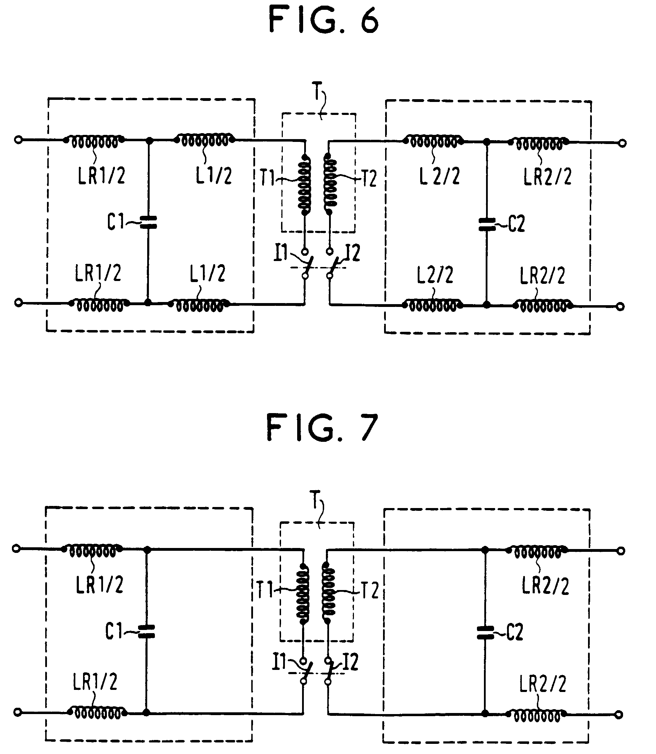

La position de $LR_1$ (ou $LR_2$) sur l'une des bornes du schéma ne privilégie aucune polarité, puisque le fonctionnement reste le même lorsque $LR_1$ (ou $LR_2$) est répartie en deux inductances de valeur moitié, en série avec chacune des connexions, respectivement $\frac{1}{2}$ ($LR_1$) et $\frac{1}{2}$ ($LR_2$) comme illustré sur les schémas des figures 6 et 7 correspondant respectivement aux schémas des figures 4 et 5.

C'est d'ailleurs cette disposition qui est adoptée de préférence en téléphonie pour symétriser chaque fil par rapport à la terre et éviter ainsi l'apparition d'un mode différentiel dans le cas d'induction de mode commun. Il en est de même pour $L_1$ et $L_2$. Les deux capacités $C_1$ et $C_2$ sont en général identiques lorsque le rapport de transformation du transformateur est égal à l'unité. Si l'on profite de l'isolation galvanique pour faire une adaptation de tension ou d'impédance, le rapport de transformation peut être différent de 1 et on peut notamment choisir les capacités pour que leur valeur ramenée du même côté du transformateur soit identique. Ainsi si l'on appelle n le rapport de trnsformation de $T_1$ vers $T_2$ (n= $\frac{n2}{n1}$, on peut notamment choisir $C_1$ et $C_2$ telles que : $\frac{C_1}{C_2}$ = $n^2$.

On notera que dans les quatre cas cités précédemment la symétrie du schéma est telle qu'il n'est pas possible de définir un sens préférentiel de passage de l'énergie, ni de particulariser un "primaire" ou un "secondaire".

De même, si les interrupteurs électroniques eux-mêmes sont réversibles en courant/tension, aucune polarité préférentielle d'un côté, ni de l'autre du schéma, ne peut être définie.

On décrit maintenant dans ce qui suit des exemples de réalisation de tels interrupteurs réversibles.

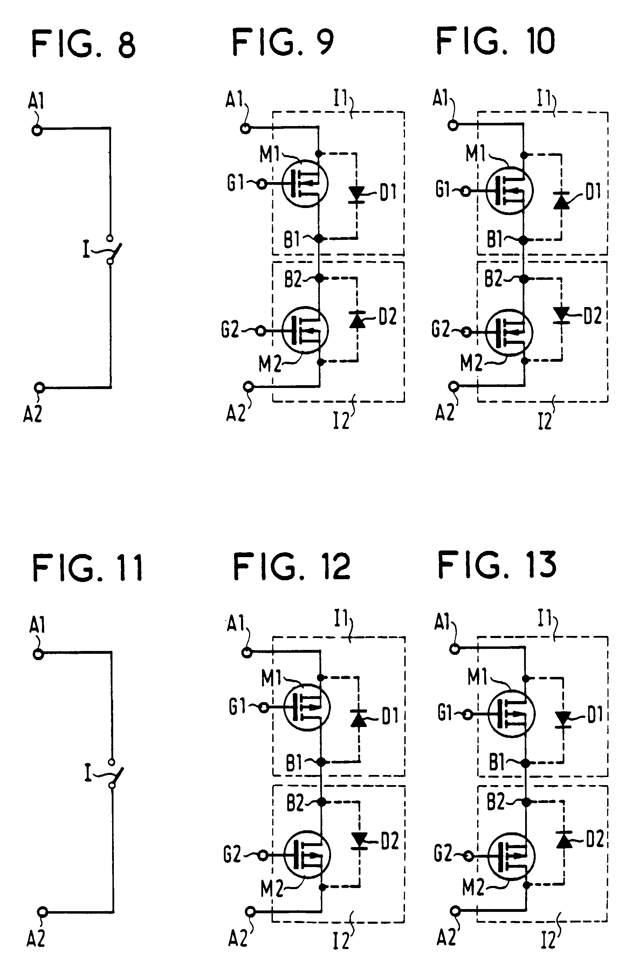

Un premier exemple de réalisation d'un interrupteur réversible utilise deux transistors MOS, et leur diode parasite interne, suivant un montage série tel que celui illustré par exemple sur les figures 9 et 10 dans le cas de transistors MOS canal N, ou celui illustré par exemple sur les figures 12 et 13 dans le cas de transistors MOS canal P (le schéma symbolique de l'interrupteur étant dans tous les cas rappelé en regard, respectivement en figures 8 et 11).

Ainsi, dans le cas du schéma de la figure 9 par exemple, avec la source de chacun de ces transistors $M_1$ et $M_2$ connectée à l'une des bornes respectivement $A_1$ et $A_2$ de l'interrupteur, lorsque la borne $A_1$ est positive par rapport à la borne $A_2$, la diode parasite $D_1$ du transistor $M_1$ conduit, et la tension se retrouve appliquée sur le transistor $M_2$ qui conduit le courant dans le sens drain-source si la tension de $G_2$ (grille du transistor $M_2$) par rapport à $A_2$ est positive et supérieure au seuil de mise en conduction, ou bloque le courant si la tension de $G_2$ par rapport à $A_2$ est inférieure au seuil de mise en conduction.

Lorsque la borne $A_2$ est positive par rapport à la borne $A_1$, le fonctionnement est symétrique et le courant passant par la diode $D_2$ parasite de $M_2$ s'écoule à travers $M_1$ du drain à la source lorsque la tension entre $G_1$ (grille du transistor $M_1$) et $A_1$ est supérieure au seuil de conduction.

Dans le cas du schéma de la figure 10, avec le drain de chacun de ces transistors $M_1$ et $M_2$ connecté à l'une des bornes, respectivement $A_1$ et $A_2$ de l'interrupteur, on obtient un résultat du même type en remplaçant la tension de $G_2$ par rapport à $A_2$ par la tension $G_1$ par rapport à $B_1$ et la tension de $G_1$ par rapport à $A_1$ par la tension de $G_2$ par rapport à $B_2$ d'une part et en permutant les rôles joués par $D_1$ et $D_2$, ainsi que par $M_1$ et $M_2$ d'autre part.

La commande de $G_1$ et $G_2$ peut être simultanée si l'on ne connait pas, a priori, la polarité appliquée entre $A_1$ et $A_2$. Le passage du courant entre $A_1$ et $A_2$ résulte

alors directement de la polarité appliquée entre $A_1$ et $A_2$.

Il faut noter que les commandes de $G_1$ et $G_2$ ne sont pas au même potentiel puisque dans le premier cas (figure 9) par exemple la commande de $G_1$ se fait par rapport à $A_1$ et celle de $G_2$ par rapport à $A_2$. La commande des transistors MOS peut se faire à l'aide de procédés connus d'isolement galvanique des commandes comme par exemple ceux utilisant des transformateurs d'impulsion ou des optocoupleurs.

On peut utiliser de la même manière des transistors MOS canal P pour réaliser l'interrupteur reversible, comme illustré sur les schémas correspondants des figures 12 et 13.

Dans le cas de la figure 12 par exemple, le fonctionnement est similaire puisque, par exemple, lorsque $A_1$ est positif par rapport à $A_2$, la diode $D_2$ parasite du transistor $M_2$ conduit le courant traversant le transistor $M_1$ lorsque le potentiel de $G_1$ par rapport à $A_1$ est négatif et supérieur en valeur absolue au seuil de mise en conducteur. Dans ce cas également les commandes de $G_1$ et $G_2$ peuvent se faire en synchronisme, et elles sont également référencées à des potentiels différents.

Pour des fréquences élevées de fonctionnement, il se peut que les diodes parasites ne soient pas assez rapides ou présentent un courant inverse trop élevé. On peut dans de tels cas éliminer le fonctionnement de la diode parasite interne en plaçant en série avec chaque transistor une diode DS présentant les caractéristiques de rapidité requises, puis, en parallèle avec cet ensemble, une deuxième diode DP semblable, se substituant à la diode parasite.

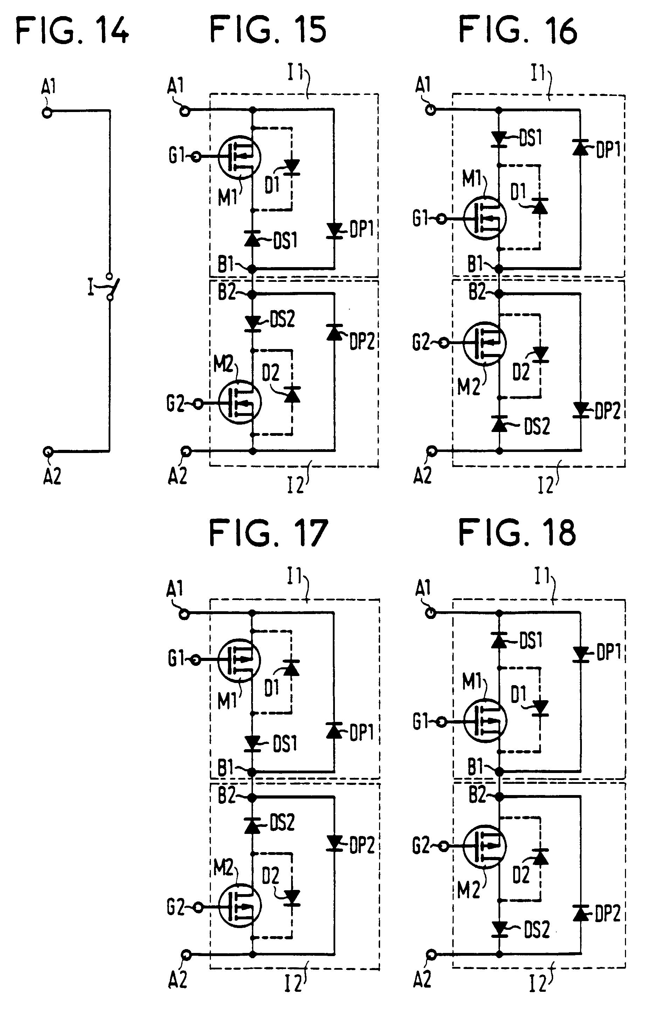

Les schémas correspondants font l'objet des figures 15 et 16 pour le cas de transistors MOS canal N, et des figures 17 et 18 pour le cas de transistors MOS canal N, le schéma symbolique de l'interrupteur étant également rappelé en regard, sur la figure 14. Là encore, $G_1$ et $G_2$ peuvent être commandés simultanément.

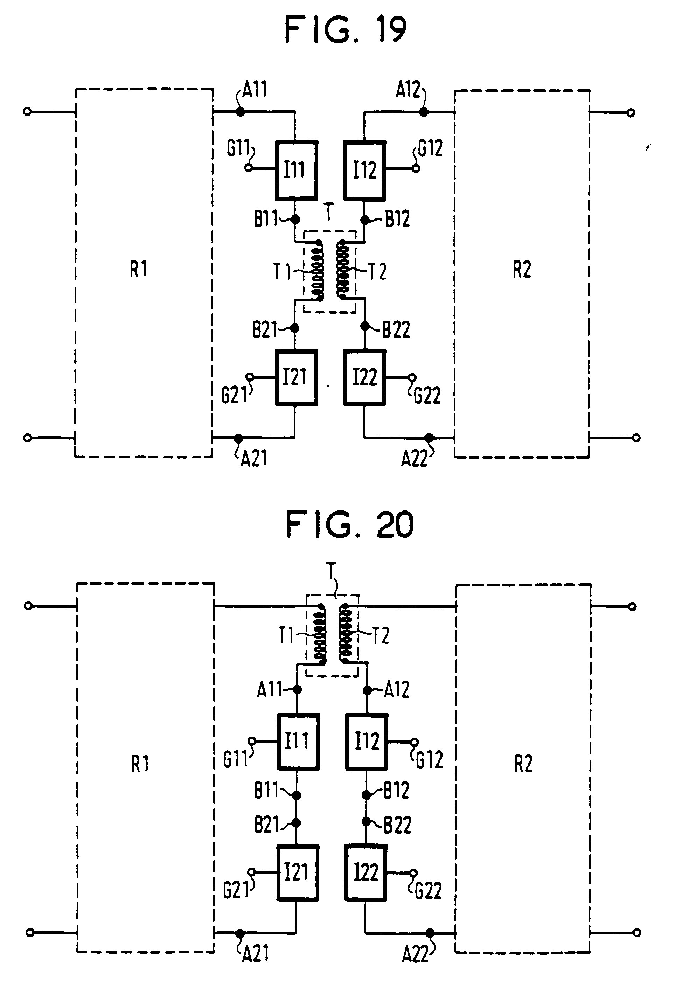

On peut maintenant noter que les schémas précédents possèdent tous un axe horizontal de symétrie. On peut utiliser cette propriété pour augmenter la symétrie des schémas des figures 2, 3, 4, 5, 6, 7 en séparant chacun des interrupteurs $I_1$, $I_2$ en deux interrupteurs élémentaires appelés demi-interrupteurs, respectivement $I_{11}$, $I_{21}$ et $I_{12}$, $I_{22}$ disposés chacun de part et d'autre de l'enroulement correspondant du transformateur. Ainsi, que le fonctionnement soit résonnant ou non, et que les interrupteurs soient commandés en synchronisme ou à l'alternat, on obtient la disposition générale représentée sur la figure 19 où les circuits notés $R_1$ et $R_2$ désignent l'ensemble des circuits nécessaires à la résonnance, dans le cas où celle-ci est utilisée, et/ou au filtrage.

On voit que cette disposition, si elle est utile pour la symétrie du montage par rapport à la terre (ou à la masse) n'est pas nécessaire au fonctionnaient tel qu'il a été exposé plus haut. Celui-ci reste inchangé dans la disposition illustrée sur la figure 20, ne présentant pas de symétrie par rapport à un axe horizontal.

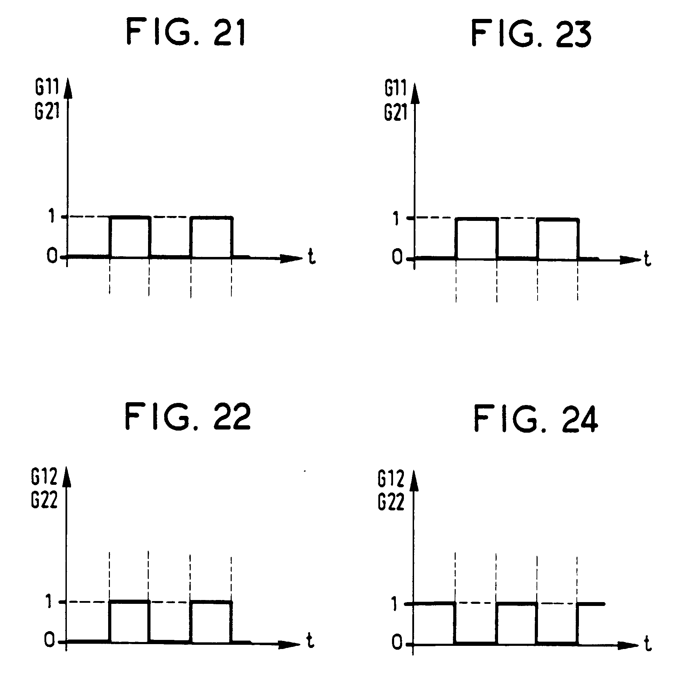

Pour les deux dispositions précédentes on peut soit commander les grilles $G_{11}$, $G_{21}$, $G_{12}$, $G_{22}$ des quatre demi-interrupteurs en même temps, comme illustré sur les chronogrammes des figures 21 et 22, soit commander $G_{11}$, $G_{21}$ en synchronisme d'une part et $G_{12}$, $G_{22}$ en synchronisme d'autre part, comme illustré sur les chronogrammes des figures 23 et 24, chacun des deux groupes étant en opposition de phase l'un par rapport à l'autre.

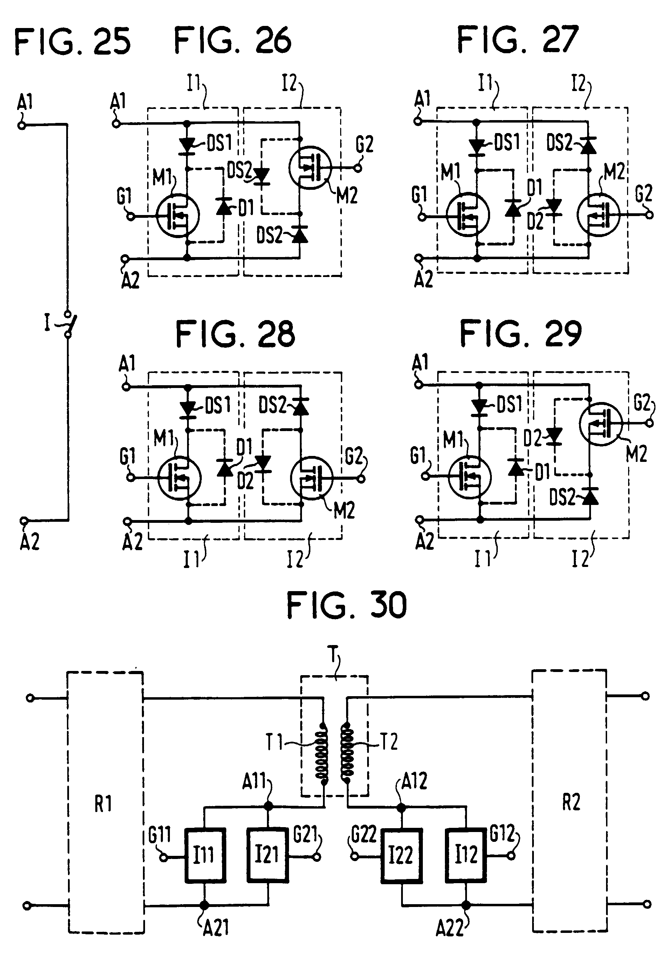

On peut aussi réaliser un interrupteur réversible avec une disposition anti-parallèle des transistors MOS $M_1$ et $M_2$. Cette orientation conduit, selon le type de transistors MOS utilisé, aux schémas des figures 26, 27 28 ou 29, le schéma symbolique d'un interrupteur étant rappelé en regard sur la figure 25.

Chacune des branches de ces montages comporte, outre l'un des transistors $M_1$, $M_2$, une diode respectivement $D_{S1}$, $D_{S2}$, placée en série avec ce transistor et permettant de bloquer le courant dans cette branche pour l'une des polarités de tension appliquée pour laquelle la diode parasite interne, respectivement $D_1$, $D_2$, du transistor considéré, conduit.

La disposition relative de $DS_j$ et de $M_j$ (j=1,2) dans une même branche peut être inversée sans changement du fonctionnement.

L'avantage des schémas des figures 27 et 28, où les deux transistors M1 et M2 ont leur source connectée à une même borne de l'interrupteur, en l'occurrence la borne $A_2$, réside dans le fait que le potentiel de référence pour la commande de $G_1$ et de $G_2$ est le même, en l'occurrence le potentiel de $A_2$, ce qui peut être mis à profit pour simplifier l'électronique de commande de ces transistors.

La commande de $G_1$ et $G_2$ peut, là encore, être simultanée, et dans ce cas, le sens du courant résultera de la polarité de la tension appliquée, ou bien la commande d'un des deux demi-interrupteurs peut être choisie en fonction d'une mesure du sens de la tension appliquée à l'interrupteur complet.

De la même manière que dans le cas de demi-interrupteurs mis en série, les demi-interrupteurs en anti-parallèle permettent de construire le schéma général d'un dispositif d'isolement galvanique, représenté sur la figure 30.

Egalement de la même manière que dans le cas de demi-interrupteurs mis en série, on peut commander soit $G_{11}$, $G_{21}$, $G_{12}$, $G_{22}$ en même temps, comme illustré sur les chronogrammes qui font l'objet des figures 21 et 22, soit commander $G_{11}$, $G_{21}$ en synchronisme d'une part et $G_{12}$, $G_{22}$ en synchronisme d'autre part, chacun des deux groupes étant en opposition de phase par rapport à l'autre, comme illustré sur les chronogrammes qui font l'objet des figures 23 et 24.

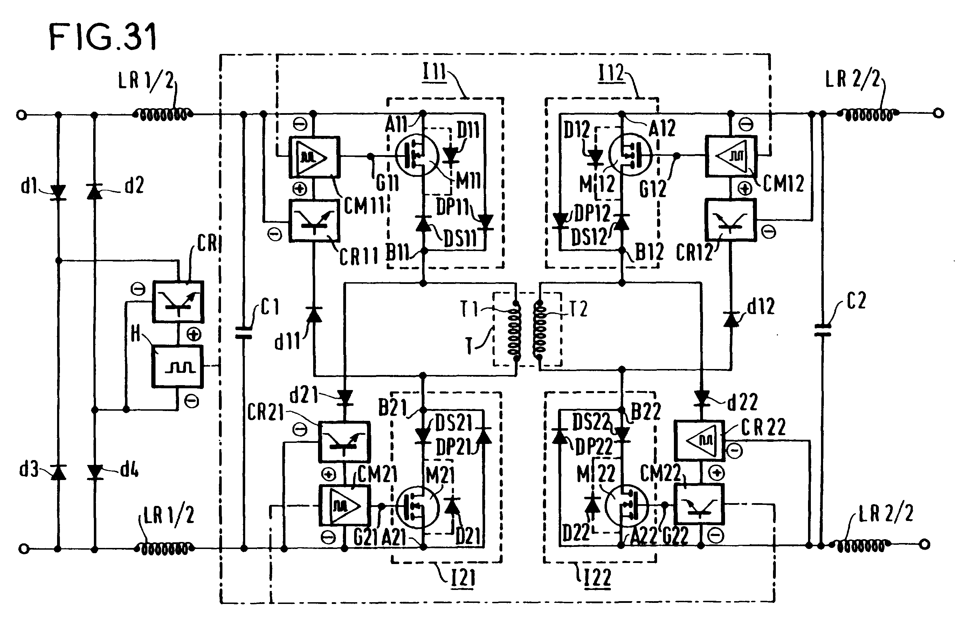

La stratégie de commande du dispositif ainsi décrit se résume donc à piloter deux interrupteurs électroniques $I_1$ et $I_2$ à une fréquence supérieure à deux fois la plus haute fréquence à transmettre contenue dans le signal incident, ces interrupteurs électroniques étant pilotés en phase ou en opposition de phase selon le procédé choisi, au moyen d'un signal d'horloge fourni par une horloge, repérée H sur le schéma de la figure 31 qui inclut les éléments de commande des quatre demi-interrupteurs $I_{11}$, $I_{21}$, $I_{12}$, $I_{22}$, disposés à titre d'exemple suivant le schéma de la figure 19.

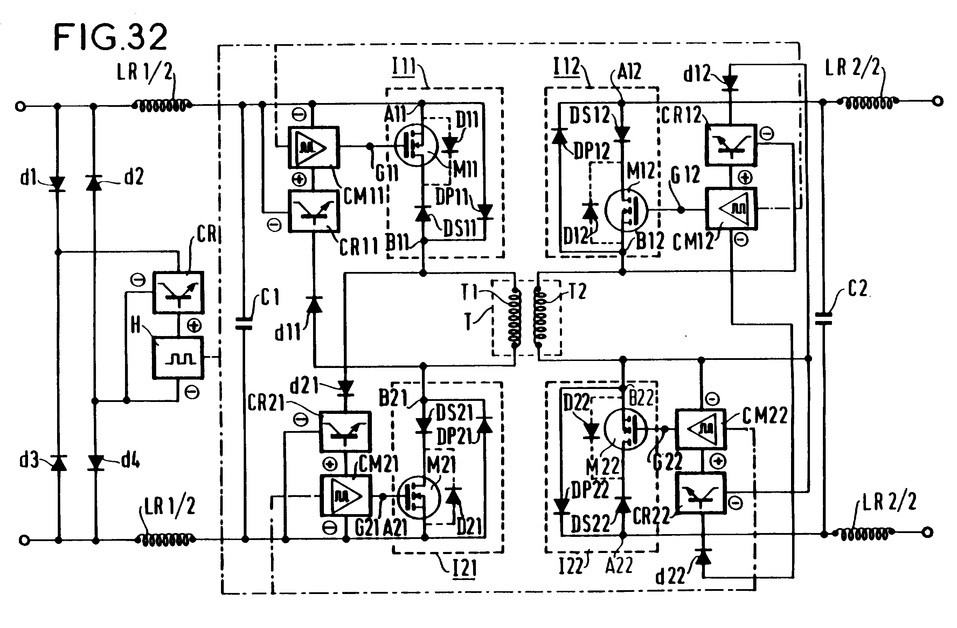

Les schémas des figures 31 et 32 correspondent à titre d'exemple au cas d'un convertisseur direct résonnant, utilisant des interrupteurs électroniques composés de transistors MOS canal N avec une disposition série (en l'occurrence suivant le schéma de la figure 15 pour l'ensemble des demi-interrupteurs dans le cas de la figure 31, et pour les deux demi-interrupteurs $I_{11}$ et $I_{21}$ dans le cas de la figure 32, les deux autres demi-interrupteurs $I_{12}$ et $I_{22}$ étant en l'occurrence montés suivant le schéma de la figure 16) et une horloge alimentée par le signal incident susceptible d'inversion, et sans isolement galvanique.Il suffit alors de commander quatre demi-interrupteurs, c'est-à-dire quatre interrupteurs électroniques élémentaires, avec la bonne phase, tout en maintenant un isolement galvanique entre l'horloge et chacun des demi-interrupteurs électroniques.

Dans ces schémas l'horloge H est alimentée par le signal incident à travers un pont de diodes $d_1$, $d_2$, $d_3$, $d_4$ et un circuit de regulation CR, et la commande des demi-interrupteurs avec un isolement galvanique entre l'horloge et chacun de ces demi-interrupteurs est symbolisée par une liaison en pointillé.

Il faut noter que seules les commandes des deux demi-interrupteurs se situant de l'autre côté du transformateur par rapport à la prise d'alimentation de l'horloge doivent supporter le même potentiel d'épreuve que l'isolation électrique principale du transformateur. Les deux autres demi-interrupteurs électroniques ne doivent en outre être isolés de l'horloge que dans la mesure où l'on utilise l'inversabilité de la polarité d'entrée et que l'alimentation de l'horloge n'est pas elle-même isolée du signal. Dans ce cas, par exemple lorsque l'horloge est alimentée à travers un pont de diode à partir du signal lui-même, ce qui correspond au schéma de la figure 31 ou 32, il est nécessaire de prévoir une isolation entre l'horloge et, selon le schéma retenu pour l'interrupteur chacun des deux demi-interrupteurs (ce qui est le cas des figures 31 et 32) ou bien l'ensemble des deux demi-interrupteurs, eux-mêmes à un même potentiel, (ce qui serait par exemple le cas avec un schéma d'interrupteur tel que celui qui fait l'objet des figures 27 et 28). Cette isolation ne devra être prévue que pour un isolement en accord avec la tension maximale du signal lui-même, donc la tension différentielle, et non plus pour la tension de mode commun maximum susceptible de se manifester entre les deux enroulements du transformateur principal.

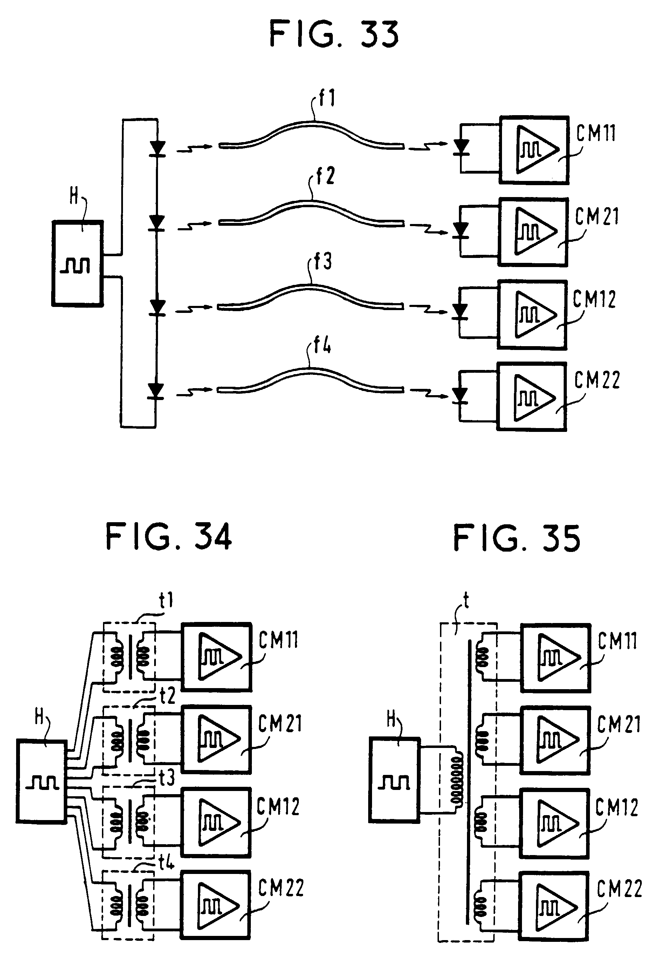

Les figures 33, 34, 35 représentent respectivement un mode de pilotage des quatre demi-interrupteurs par quatre fibres optiques $f_1$, $f_2$, $f_3$, $f_4$, quatre transformateurs d'impulsions $t_1$, $t_2$, $t_3$, $t_4$ et un seul transformateur "t" muni d'un primaire et de quatre secondaires.

Les signaux d'horloge ainsi reçus pour chacun de ces demi-interrupteurs sont en l'occurrence appliqués sur leur grille par l'intermédiaire d'une électronique de pilotage comportant un circuit de mise en forme et d'amplification d'impulsions, respectivement CM$_{11}$, CM$_{21}$, CM$_{12}$, CM$_{22}$ et un circuit d'alimentation régulée, respectivement CR$_{11}$, CR$_{21}$, CR$_{12}$, CR$_{22}$. Chacun des circuits d'alimentation régulée est muni d'une référence de potentiel, repérée "-", d'une sortie, repérée "+", et d'une entrée d'énergie, non repérée. Chacun des circuits de mise en forme et d'amplification d'impulsions, ainsi que l'horloge, est muni d'une entrée d'alimentation, repérée "+", d'une entrée de référence de potentiel, repérée "-", et d'une sortie, non repérée.

Dans un schéma tel que celui de la figure 31 qui est un exemple de cas le plus complexe vis-à-vis des commandes des interrupteurs électroniques, il faut prévoir quatre alimentations pour les électroniques de pilotage des demi-interrupteurs électroniques.

Il faut noter que si l'on utilise un ou des transformateurs d'impulsions, ceux-ci peuvent transmettre suffisamment d'énergie pour commander directement les demi-interrupteurs sans autre intermédiaire. Dans ce cas, il n'est point besoin d'alimentation en local ni d'amplification d'impulsion.

Avec une commande optique, une électronique de mise en forme et d'amplification du signal de commande du demi-interrupteur est nécessaire et celle-ci a besoin elle-même d'une alimentation.

Les schémas des figures 31 et 32 montrent comment l'obtenir à partir du signal lui-même si l'on veut se passer d'une source extérieure. L'entrée d'alimentation de chacun des circuits de mise en forme et d'amplification d'impulsions est reliée, par l'intermédiaire du circuit de régulation associé, à une diode, respectivement $d_{11}$, $d_{21}$, $d_{12}$, $d_{22}$, elle même connectée à l'une des bornes de l'enroulement correspondant du transformateur principal T. Selon la polarité du signal, l'énergie est ainsi prélevée soit directement sur le signal lui-même, soit sur le transformateur principal T, à l'aide des surtensions inverses générées par la commutation de l'interrupteur contrôlant le courant magnétisant. On obtient alors dans ce dernier cas une véritable récupération de l'énergie magnétisante du transformateur T, énergie utilisée pour alimenter les circuits électroniques de mise en forme et d'amplification des commandes, ce qui a pour effet supplémentaire de limiter les surtensions d'ouverture du circuit.

Dans le cas des figures 31 et 32, notamment, on est amené à commander simultanément les deux demi-interrupteurs électroniques appartenant au même interrupteur, alors que, selon les conditions électriques externes, un seul va conduire, fixant la direction du courant. Cette statégie conduit à faire débiter l'alimentation des circuits de commande du demi-interrupteur qui ne conduit pas de courant, en pure perte.

Ceci peut être dommageable, lorsque l'alimentation desdits circuits, est prélevée sur le signal, ou lorsqu'en général on souhaite un rendement global très élevé.

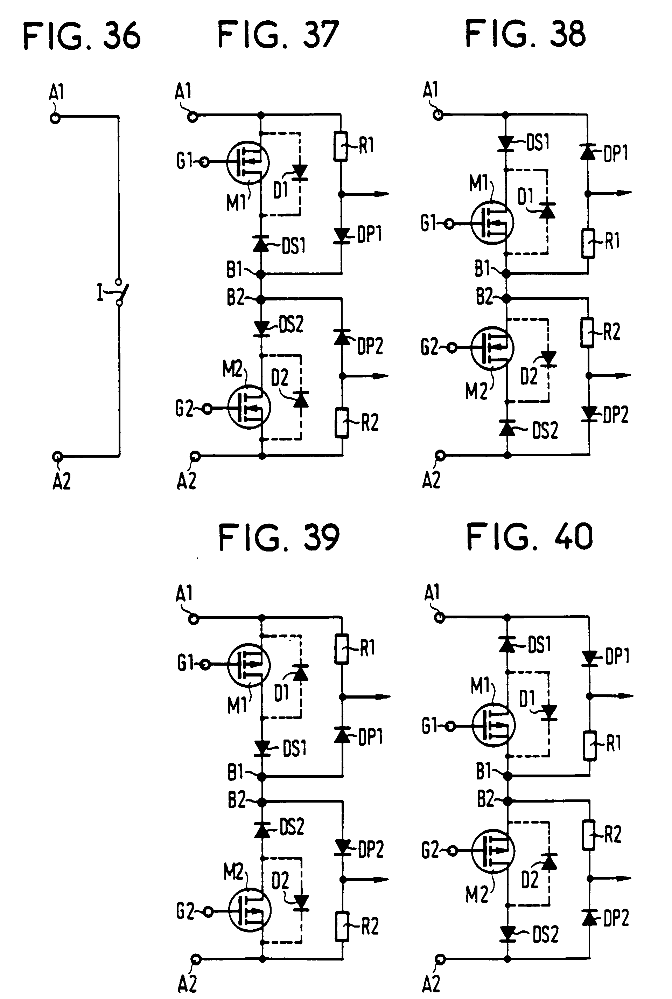

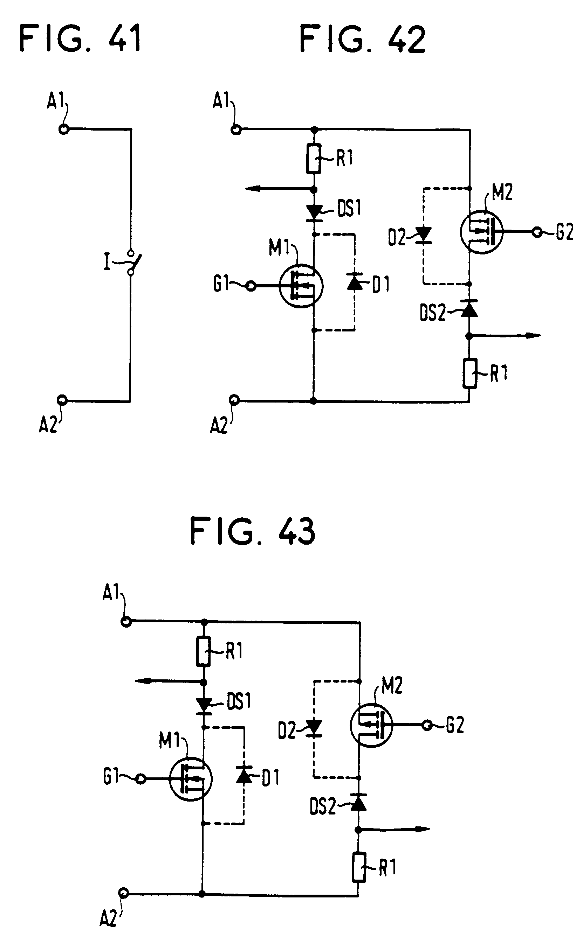

Pour éviter ceci, on peut bloquer l'alimentation et le fonctionnement de l'électronique de commande du demi-interrupteur qui n'est traversé par aucun courant en détectant le courant dans l'autre demi-interrupteur ou le courant circulant en inverse dans la diode en anti-parallèle sur le demi-interrupteur, à l'aide d'une simple résistance $R_1$, $R_2$ comme cela est représenté à titre d'exemple sur les schémas de principe donnés d'une part en figures 37, 38, 39, 40 pour un interrupteur, dont le schéma symbolique est rappelé en regard sur la figure 36, formé de demi-interrupteurs montés en série conformément aux montages des figures 15, 16, 17, 18, et d'autre part en figures 42 et 43, pour un interrupteur, dont le schéma symbolique est rappelé en regard sur la figure 41, formé de demi-interrupteurs montés en anti-parallèle, conformément aux montages des figures 26 et 29.

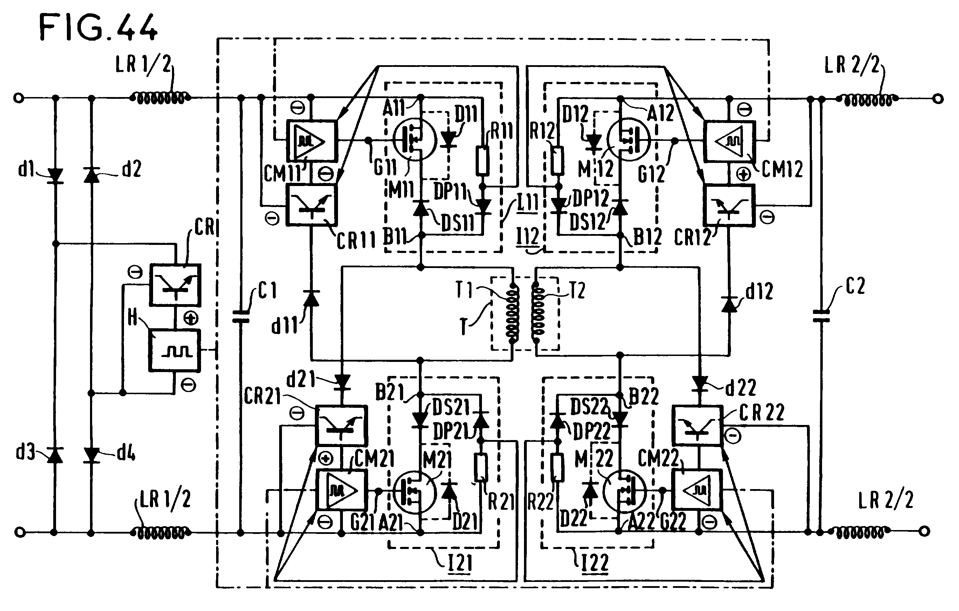

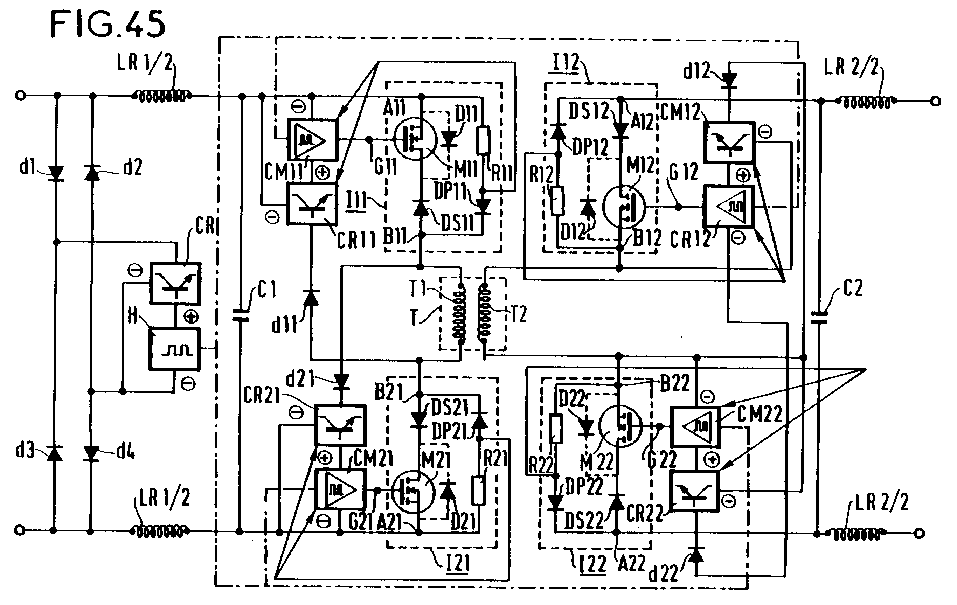

De la même manière, les schémas de principe de convertisseurs directs résonnants, utilisant des interrupteurs électroniques réversibles composés de transistors MOS canal N avec une disposition série et une horloge alimentée par le signal, susceptible d'inversion, et sans isolement galvanique, avec de plus une disposition symétrique par rapport aux conducteurs qui véhiculent l'information, peuvent être à titre d'exemple l'un des schémas des figures 44 et 45, correspondant à ceux des figures 31 et 32, et où la détection par une résistance, respectivement $R_{11}$, $R_{21}$, $R_{12}$, $R_{22}$, du passage du courant inverse dans le demi-interrupteur correspondant, sert au blocage dudit demi-interrupteur puisqu'il n'est pas en mesure de conduire en direct. Dans ce cas, les alimentations régulées CRii (i= 1 à 2) et les amplificateurs d'impulsion CMii (i = 1 à 2) possèdent une entrée supplémentaire de contrôle (fléchée) permettant le blocage de ces deux fonctions.

## Revendications

1. Dispositif d'isolement galvanique pour signaux électriques permettant la réversibilité du sens de l'écoulement de l'énergie électrique comportant un transformateur (T), caractérisé en ce que:

   - lesdits signaux électriques sont alternatifs ou alternatifs susceptibles de comporter une composante continue,
   - ledit dispositif comporte:

     - des premiers moyens de découpage ($I_1$, $I_2$) du signal incident appliqué à l'un des enroulements dudit transformateur, lesdits premiers moyens de découpage étant disposés en série avec ledit enroulement dudit transformateur,
     - des second moyens de découpage ($I_2$, $I_1$) du signal incident obtenu à l'autre enroulement dudit transformateur, lesdits seconds moyens de découpage étant disposés en série avec ledit autre enroulement dudit transformateur,

     lesdits premiers et seconds moyens de découpage étant réversibles en courant et lesdits seconds moyens de découpage étant commandés soit en phase, soit en opposition de phase avec lesdits premiers moyens de découpage, et
   - des moyens de filtrage ($F_1$, $F_2$) des signaux découpés ainsi obtenus audit autre enroulement, lesdits moyens de filtrage constituant l'entrée et la sortie dudit dispositif d'isolement galvanique,

   ledit dispositif permettant l'inversion de tension desdits signaux électriques au primaire et au secondaire dudit tranformateur.

2. Dispositif selon la revendication 1, caractérisé en ce qu'il est reversible et comporte, associés à chacun desdits enroulements, des moyens réversibles de découpage ($I_1$, $I_2$) et des moyens de filtrage ($F_1$, $F_2$).

3. Dispositif selon l'une des revendications 1 et 2, caractérisé en ce que le signal incident comportant une composante alternative, lesdits moyens de découpage sont commandés à une fréquence supérieure à deux fois la plus haute fréquence à transmettre contenue dans le signal incident.

4. Dispositif selon l'une des revendications 1 à 3, caractérisé en ce que les moyens de découpage réversibles comportent des interrupteurs à semi-conducteurs.

5. Dispositif selon l'une des revendications 1 à 4, caractérisé en ce que chacun desdits moyens de découpage réversibles comporte deux interrupteurs élémentaires à semi-conducteurs, dits demi-interrupteurs ($I_{11}$, $I_{12}$, $I_{21}$, $I_{22}$) , montés en série et présentant des sens de conduction opposés, le sens de conduction étant pour chacun de ces interrupteurs identique au sens de conduction par la diode parasite interne ($D_1$, $D_2$) de l'autre interrupteur.

6. Dispositif selon la revendication 5, caractérisé en ce que, pour des fréquences élevées de fonctionnement, une première et une deuxième diode ($D_{S1}$, $D_{S2}$, $D_{P1}$, $D_{P2}$) présentant les caractéristiques de rapidité requises sont associées à chaque interrupteur pour respectivement éliminer le fonctionnement de sa diode parasite interne ($D_1$, $D_2$) et se substituer à celle-ci.

7. Dispositif selon l'une des revendications 1 à 5, caractérisé en ce que chacun desdits moyens de découpage comporte deux interrupteurs élémentaires à semi-conducteurs dits demi-interrupteurs ($I_{11}$, $I_{12}$, $I_{21}$, $I_{22}$) montés en anti-parallèle, présentant des sens de conduction opposés, et connectés chacun en serie avec une diode ($D_{S1}$, $D_{S2}$) présentant un sens de conduction opposé à celui de sa diode parasite interne.

8. Dispositif selon l'une des revendications 5 et 6, caractérisé en ce que ces deux demi-interrupteurs sont montés de part et d'autre de l'enroulement correspondant du transformateur (T).

9. Dispositif selon l'une des revendications 4 à 8, caractérisé en ce que les sigaux de commande desdits demi-interrupteurs à semi-conducteurs sont issu d'une horloge commune, et appliqués à l'électrode de commande de chacun desdits demi-interrupteurs via des moyens d'isolement galvanique du signal issu de cette horloge commune.

10. Dispositif selon la revendication 9, caractérisé en ce que, les signaux de commande desdits interrupteurs à semi-conducteurs étant appliqués à ceux-ci via des moyens de commande électroniques opérant sur les signaux issus de ladite horloge commune, et propres à chacun desdits interrupteurs, ces demi-interrupteurs à semi-conducteurs correspondants ont une alimentation locale, référencée par rapport à leur électrode de référence.

11. Dispositif selon la revendication 10, caractérisé en ce que ladite alimentation locale est obtenue par prélèvement d'énergie sur les signaux transitant dans ce dispositif.

12. Dispositif selon l'une des revendications 10 et 11, caractérisé en ce qu'il comporte des moyens de blocage d'alimentation desdits moyens de commande électroniques, et/ou desdits moyens de commande électroniques eux-mêmes, pour celui des deux demi-interrupteurs qui n'est pas commandé en conduction.

13. Dispositif selon la revendication 12, caractérisé en ce que lesdits moyens de blocage comportent un moyen de détection d'absence de courant traversant ledit demi-interrupteur.

14. Dispositif selon les revendications 6 et 12, caractérisé en ce que lesdits moyens de blocage comportent un moyen de détection de présence de courant dans la diode extérieure de substitution à la diode parasite interne dudit demi-interrupteur.

## Patentansprüche

1. Vorrichtung zur galvanischen Isolierung für elektrische Signale, wobei die Vorrichtung eine Umkehr der Flußrichtung der elektrischen Energie erlaubt und einen Transformator (T) besitzt, dadurch gekennzeichnet, daß die elektrischen Signale Wechselstromsignale sind, die auch eine Gleichkomponente enthalten können und daß die Vorrichtung aufweist:

   - erste Zerhackermittel ($I_1$, $I_2$) für das an eine der Wicklungen des Transformators ankommende Signal, wobei diese ersten Zerhackermittel in Reihe mit der Wicklung des Transformators geschaltet sind,
   - zweite Zerhackermittel ($I_2$, $I_1$) für das an der anderen Wicklung des Transformators erhaltene ankommende Signal,

   wobei diese zweiten Zerhackermittel in Reihe mit der zweiten Wicklung des Transformators liegen, wobei die ersten und zweiten Zerhackermittel hinsichtlich des Stroms reversibel sind und die zweiten Zerhackermittel entweder in Phase oder in Gegenphase mit den ersten Zerhakkermitteln gesteuert werden,

   - und Filtermittel ($F_1$, $F_2$) zum Filtern der so an der anderen Wicklung erhaltenen zerhackten Signale, wobei diese Filtermittel den Eingang und den Ausgang der Vorrichtung zur galvanischen Isolierung bilden und wobei die Vorrichtung die Richtungsumkehr der Spannung der elektrischen Signale auf der Primär- und Sekundärseite des Transformators erlaubt.

2. Vorrichtung nach Anspruch 1, dadurch gekennzeichnet, daß sie umkehrbar ist und in Verbindung mit jeder Wicklung reversible Zerhackermittel ($I_1$, $I_2$) und Filtermittel ($F_1$, $F_2$) aufweist.

3. Vorrichtung nach einem der Ansprüche 1 und 2, dadurch gekennzeichnet, daß das ankommende Signal eine Wechselstromkomponente enthält und die Zerhackermittel mit einer Frequenz gesteuert werden, die höher als das Doppelte der höchsten zu übertragenden Frequenz im ankommenden Signal ist.

4. Vorrichtung nach einem der Ansprüche 1 bis 3, dadurch gekennzeichnet, daß die umkehrbaren Zerhackermittel Halbleiter-Unterbrecher enthalten.

5. Vorrichtung nach einem der Ansprüche 1 bis 4, dadurch gekennzeichnet, daß jedes der umkehrbaren Zerhackermittel zwei elementare Halbleiter-Unterbrecher, Halb-Unterbrecher ($I_{11}$, $I_{12}$, $I_{21}$, $I_{22}$) ge-

nannt, aufweist, die in Reihe geschaltet sind und entgegengesetzte Leitrichtung besitzen, wobei die Leitrichtung für jeden dieser identischen Unterbrecher der Leitrichtung gleicht, die die interne Stördiode ($D_1$, $D_2$) des anderen Unterbrechers besitzt.

6. Vorrichtung nach Anspruch 5, dadurch gekennzeichnet, daß für hohe Betriebsfrequenzen eine erste und eine zweite Diode ($D_{S1}$, $D_{S2}$, $D_{P1}$, $D_{P2}$) mit den gewünschten Geschwindigkeitsmerkmalen jedem Unterbrecher zugeordnet ist, um die Wirkung der internen Stördiode ($D_1$, $D_2$) zu unterbinden und diese zu ersetzen.

7. Vorrichtung nach einem der Ansprüche 1 bis 5, dadurch gekennzeichnet, daß jedes der Zerhackermittel zwei elementare Halbleiter-Unterbrecher, Halb-Unterbrecher ($I_{11}$, $I_{12}$, $I_{21}$, $I_{22}$) genannt, aufweist, die in Antiparallelschaltung angeordnet sind und entgegengesetzte Leitrichtung besitzen, sowie je mit einer Diode ($D_{S1}$, $D_{S2}$) in Reihe geschaltet sind, deren Leitrichtung der der internen Stördiode entgegengesetzt ist.

8. Vorrichtung nach einem der Ansprüche 5 und 6, dadurch gekennzeichnet, daß die beiden Halb-Unterbrecher zu beiden Seiten der entsprechenden Wicklung des Transformators (T) angeordnet sind.

9. Vorrichtung nach einem der Ansprüche 4 bis 8, dadurch gekennzeichnet, daß die Steuersignale für die halbleitenden Halb-Unterbrecher von einem gemeinsamen Taktgeber stammen und an die Steuerelektrode jedes der Halb-Unterbrecher über galvanische Isoliermittel für das vom gemeinsamen Taktgeber kommende Signal angelegt sind.

10. Vorrichtung nach Anspruch 9, dadurch gekennzeichnet, daß die Steuersignale der halbleitenden Halb-Unterbrecher an diese über elektronische Steuermittel angelegt werden, die von aus dem gemeinsamen Taktgeber stammenden Signalen angesteuert werden und jedem der Unterbrecher zugeordnet sind, und daß diese halbleitenden Halb-Unterbrecher eine örtliche Speiseschaltung besitzen, die sich auf ihre Bezugselektrode bezieht.

11. Vorrichtung nach Anspruch 10, dadurch gekennzeichnet, daß die örtliche Speiseschaltung Energie aus den durch die Vorrichtung verlaufenden Signalen entnimmt.

12. Vorrichtung nach einem der Ansprüche 10 und 11, dadurch gekennzeichnet, daß sie Mittel zur Blockierung der Speiseschaltung für die elektronischen Steuermittel und/oder der elektronischen Steuermittel selbst für denjenigen der Halb-Unterbrecher aufweist, der gerade nicht leitend gesteuert wird.

13. Vorrichtung nach Anspruch 12, dadurch gekennzeichnet, daß die Blockiermittel ein Mittel aufweisen, das feststellt, ob gerade kein Strom den Halb-Unterbrecher durchquert.

14. Vorrichtung nach einem der Ansprüche 6 und 12, dadurch gekennzeichnet, daß die Blockiermittel ein Mittel aufweisen, das feststellt, ob ein Strom in der äußeren Diode fließt, die die interne Stördiode des Halb-Unterbrechers ersetzt.

**Claims**

1. Galvanic isolation device for electrical signals allowing reversing of the direction of flow of electrical energy and including a transformer (T), characterised in that:

   - said electrical signals are alternating current signals and may include a direct current component,
   - said device includes:

     - first means ($I_1$, $I_2$) for chopping the incident signal applied to one winding of said transformer, said first chopper means being in series with said winding of said transformer,
     - second means ($I_2$, $I_1$) for chopping the incident signal obtained at the other winding of said transformer, said second chopper means being in series with said other winding of said transformer,

     said first and second chopper means being reversible in terms of current and said second chopper means being controlled either in phase or in phase opposition with said first chopper means, and

     - means ($F_1$, $F_2$) for filtering chopped signals obtained in this way at said other winding, said filter means constituting the input, the output of said galvanic isolation device,

   said device allowing reversing of the voltage of said electrical signals at the primary and at the secondary of said transformer.

2. Device according to claim 1 characterised in that it is reversible and comprises, associated with each of said windings, reversible chopper means ($I_1$, $I_2$) and filter means ($F_1$, $F_2$).

3. Device according to claim 1 or claim 2 characterised in that, the incident signal comprising an alternating current component, said chopper means are controlled at a frequency more than twice the highest frequency to be transmitted contained in the incident signal.

4. Device according to any one of claims 1 to 3 characterised in that the reversible chopper means comprise semiconductor switches.

5. Device according to any one of claims 1 to 4 characterised in that each of said reversible chopper means comprises two basic semiconductor switches called half-switches ($I_{11}$, $I_{12}$, $I_{21}$, $I_{22}$) connected in series and having opposite conduction directions, the conduction direction for each of these switches being identical to the conduction direction of the internal parasitic diode ($D_1$, $D_2$) of the other switch.

6. Device according to claim 5 characterised in that, for high operating frequencies, first and second diodes ($D_{S1}$, $D_{S2}$, $D_{P1}$, $D_{P2}$) having the required speed characteristics are associated with each switch respectively to eliminate the operation of its internal parasitic diode ($D_1$, $D_2$) and to substitute for it.

7. Device according to any one of claims 1 to 5 characterised in that each of said chopper means comprises two semiconductor basic switches called half-switches ($I_{11}$, $I_{12}$, $I_{21}$, $I_{22}$) connected in anti-parallel having opposite conduction directions and each connected in series with a diode ($D_{S1}$, $D_{S2}$) having a conduction direction opposite to that of its internal parasitic diode.

8. Device according to claim 5 or claim 6 characterised in that the two half-switches are connected each on one side of the respective winding of the transformers (T).

9. Device according to any one of claims 4 to 8 characterised in that the control signals of said semiconductor half-switches are derived from a common clock and applied to the control input of each of said half-switches via means for galvanically isolating the output signal of this common clock.

10. Device according to claim 9 characterised in that, the control signals of said semiconductor switches being applied thereto via electronic control means operating on the output signals of said common clock and specific to each of said switches, the semiconductor half-switches have a local power supply referred to their reference terminal.

11. Device according to claim 10 characterised in that said local power supply is obtained by taking energy from the signals passing through the device.

12. Device according to claim 10 or claim 11 characterised in that it comprises means for disabling the power supply of said electronic control means and/or said electronic control means themselves for that of the two half-switches which is not caused to conduct.

13. Device according to claim 12 characterised in that said disabling means comprise means for detecting absence of current in said half-switch.

14. Device according to claims 6 and 12 characterised in that said disabling means comprise means for detecting presence of current in the external diode substituted for the internal parasitic diode of said half-switch.

## FIG. 1

## FIG. 2

## FIG. 3

# FIG. 4

# FIG. 5

# FIG. 6

# FIG. 7

EP 0 505 283 B1

# FIG. 8

# FIG. 9

# FIG. 10

# FIG. 11

# FIG. 12

# FIG. 13

# FIG. 14

# FIG. 15

# FIG. 16

# FIG. 17

# FIG. 18

# FIG. 19

# FIG. 20

# FIG. 21

# FIG. 23

# FIG. 22

# FIG. 24

# FIG. 25

# FIG. 26

# FIG. 27

# FIG. 28

# FIG. 29

# FIG. 30

FIG.31

FIG.32

# FIG. 33

# FIG. 34

# FIG. 35

# FIG. 36

# FIG. 37

# FIG. 38

# FIG. 39

# FIG. 40

FIG. 41

FIG. 42

FIG. 43

FIG.44

# FIG.45

EP 0 505 283 B1